# EUROPÄISCHE PATENTSCHRIFT

(11) **EP 1 911 334 B1**
(45) Veröffentlichungstag und Bekanntmachung des Hinweises auf die Patenterteilung: **20.01.2010**
(21) Anmeldenummer: 07787502.9
(22) Anmeldetag: 13.07.2007
(51) Int. Cl.: H05K 1/11

(54) **VERFAHREN UND SYSTEM ZUR ELEKTRISCHEN KOPPLUNG EINES INFORMATIONSTRÄGERS MIT EINEM KONTAKTELEMENT**
METHOD AND SYSTEM FOR ELECTRICALLY COUPLING AN INFORMATION CARRIER TO A CONTACT ELEMENT
PROCÉDÉ ET SYSTÈME DE COUPLAGE ÉLECTRIQUE D'UN SUPPORT D'INFORMATION AVEC UN ÉLEMENT DE CONTACT

(30) Priorität: 25.08.2006 DE 102006039929
(43) Veröffentlichungstag der Anmeldung: 16.04.2008
(73) Patentinhaber: Evonik Degussa GmbH, 45128 Essen (DE)
(72) Erfinder: KARACS, Gabor, 09113 Chemnitz (DE); ZILLGER, Tino, 09126 Chemnitz (DE); FRANZ, Thoralt, 09376 Oelsnitz (DE)
(74) Vertreter: Tetzner, Michael
(86) Internationale Anmeldenummer: PCT/EP2007/057234
(87) Internationale Veröffentlichungsnummer: WO 2008/022849

(56) Entgegenhaltungen:
- CH-A- 493 048
- DE-A1- 2 633 175
- DE-A1-102004 005 699
- DE-C1- 19 512 191
- US-A- 3 604 900

## Beschreibung

Die Erfindung betrifft ein Verfahren sowie ein Systems zur elektrischen Kopplung eines Informationsträgers mit einem Kontaktelement, wobei der Informationsträger eine Leitbahnstruktur mit einer Kontaktzone aufweist, die zwischen zwei fest miteinander verbundenen Substratlagen eingebettet ist, und das Kontaktelement mit der Kontaktzone in elektrischen Kontakt gebracht wird.

Aus der DE-A-10 2005 042 089 ist es bekannt, eine innenliegende elektrisch leitende Struktur derart zu erzeugen, dass solche Strukturen mit einem leitfähigen Druckstoff auf ein Substrat, beispielsweise Papier oder Folie gedruckt werden und danach mit einem Decksubstrat zusammenlaminiert werden. Die so erzeugte Leitbahnstruktur liegt somit innen zwischen zwei Substratschichten, wobei zusätzlicher Klebstoff vorhanden ist. Diese Konstruktion ist für verschiedene Anwendungen, wie beispielsweise Tastaturen aus Papier, Spielkarten mit einer elektrischen Speicherstruktur, etc., von Vorteil. Allerdings besteht bei dieser Ausführung das Problem, elektrische Signale bzw. Strom in die Leitbahnstruktur einzukoppeln.

Die DE-C1-195 12 191 betrifft einen ein- oder mehrlagig aus einem thermoplastischen Kunststoff hergestellten Datenträger, auf dem mindestens ein Speicherchip angeordnet ist, der über einen Bus bzw. Busleitungen mit einer im Randbereich des Datenträgers angeordneten Kontaktzone verbunden ist.

In der CH-A-493 048 wird eine Leiterbahnstruktur mit Kontaktzonen offenbart, die unsichtbar zwischen zwei fest miteinander verbundenen Substratlagen eingebettet sind. Ferner sind Sonden vorgesehen, die einen kapazitiven Kontakt mit der Kontaktzone herstellen können.

US 3,604,900 offenbart eine Kreditkarte mit eingebetteten Kontaktzonen, die für eine kapazitive oder induktive Kopplung vorgesehen sind.

Der Erfindung liegt daher die Aufgabe zugrunde, eine andere, einfache und sichere Möglichkeit zur elektrischen Kopplung des Informationsträgers mit einem Kontaktelement anzugeben.

Diese Aufgabe wird erfindungsgemäß durch die Merkmale der Ansprüche 1 und 5 gelöst.

Beim erfindungsgemäßen Verfahren zur elektrischen Kopplung eines Informationsträgers mit einem Kontaktelement weist der Informationsträger eine Leitbahnstruktur mit einer Kontaktzone auf, wobei die Leitbahnstruktur und die Kontaktzone unsichtbar zwischen zwei fest miteinander verbundenen Substratlagen eingebettet sind. Der Informationsträger wird zur Herstellung einer elektrischen Kopplung in einem Kontaktierungssystem zunächst derart geschnitten bzw. gestanzt, dass die Kontaktzone in einem Kantenbereich freigelegt wird und anschließend wird das Kontaktelement in diesem Kantenbereich mit der Kontaktzone in einen ohmschen Kontakt gebracht.

Das erfindungemäße System zum elektrischen Kontaktieren eines Informationsträgers, der eine Leitbahnstruktur mit einer Kontaktzone aufweist, wobei die Leitbahnstruktur und die Kontaktzone unsichtbar zwischen zwei fest miteinander verbundenen Substratlagen eingebettet sind, besteht im Wesentlichen aus einer Führungs- und Haltevorrichtung für den Informationsträger, einer Schneid- oder Stanzeinrichtung zum Freilegen der eingebetteten Kontaktzone in einem Kantenbereich des Informationsträgers, einem Kontaktelement zur ohmschen Kontaktierung der freigelegten Kontaktzone und einer Strom-/Spannungsquelle zum Anlegen eines Stromes bzw. einer Spannung an das Kontaktelement und zur Einkopplung eines entsprechenden Signals in die Leitbahnstruktur.

Durch das Freilegen der Kontaktzone in einem Kantenbereich des Informationsträgers lässt sich das Kontaktelement auf einfache Weise mit der Kontaktzone in einen ohmschen Kontakt bringen.

Weitere Ausgestaltungen der Erfindung sind Gegenstand der Unteransprüche.

Gemäß einem bevorzugten Ausführungsbeispiel wird das Kontaktelement bei der elektrischen Kontaktierung gegen die Kontaktzone gedrückt.

Die im Kantenbereich freigelegte Kontaktzone kann insbesondere flächig, linienförmig oder punktförmig ausgebildet sein.

Gemäß einer bevorzugten Ausgestaltung kommen als Substratlagen insbesondere Papier oder Folie in Betracht. Die beiden Substratlagen können dabei beispielsweise durch Laminieren zusammengeführt werden.

Weitere Vorteile und Ausgestaltungen der Erfindung werden im Folgenden anhand der Beschreibung und der Zeichnung näher erläutert.

In der Zeichnung zeigen
- Fig. 1: eine dreidimensionale Darstellung des Informationsträgers,
- Fig. 2: eine schematische Seitenansicht des Informationsträgers vor dem Schneid- bzw. Stanzvorgang,
- Fig. 3: eine schematische Ansicht des Informationsträgers kurz vor der Kontaktierung und
- Fig. 4: eine schematische Seitenansicht des Informationsträgers bei der Kontaktierung.

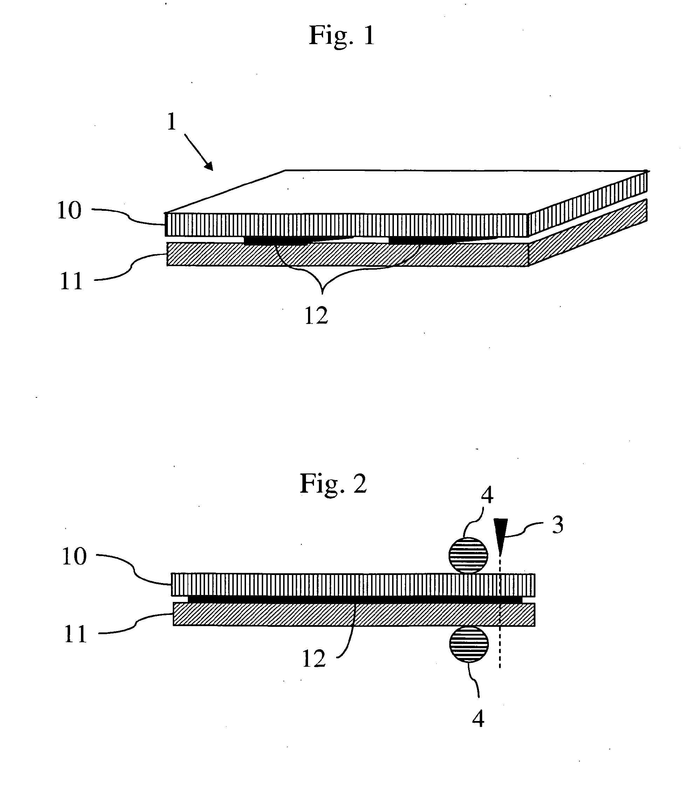

Der in Fig. 1 dargestellte Informationsträger besteht im Wesentlichen aus zwei fest miteinander verbundenen, flexiblen Substratlagen 10, 11 sowie einer zwischen den beiden Substratlagen eingebetteten Leitbahnstruktur 12.

Die beiden Substratlagen 10, 11 bestehen beispielsweise aus Papier oder Folie, wobei die Leitbahnstruktur unsichtbar zwischen den beiden Substratlagen eingebettet ist. Die Leitbahnstruktur ist in geeigneter Weise auf einer der Substratlagen aufgebracht. Als besonders vorteilhaft hat sich dabei die Verwendung von leitfähigen organischen Polymeren, insbesondere PEDOT oder PANI, herausgestellt. Diese leitfähigen organischen Polymere lassen sich auf einfache Art und Weise auf die Substratlage aufdrucken. Dabei können insbesondere Massendruckverfahren, wie Hoch-, Tief- oder Flachdruckverfahren, eingesetzt werden. Nach dem Drucken der Leitbahnstruktur werden die beiden Substratlagen 10, 11 in geeigneter Weise, beispielsweise durch Laminieren zusammengefügt.

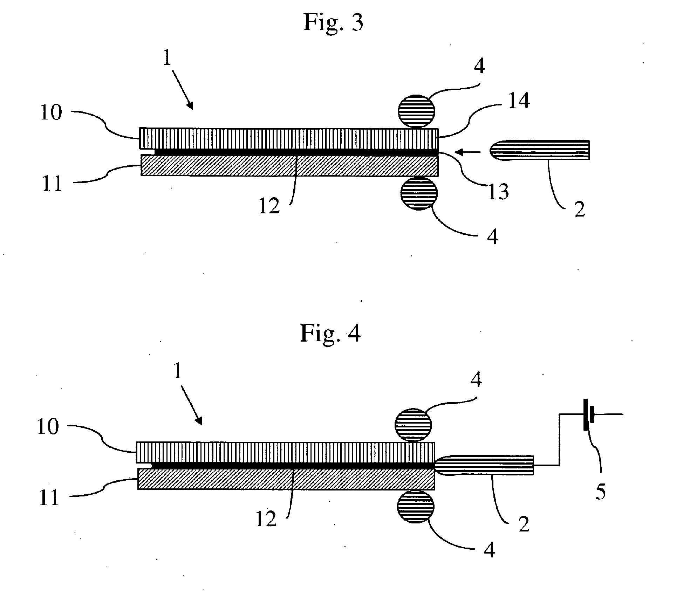

Zur elektrischen Kopplung des Informationsträgers 1 mit einem Kontaktelement 2 (siehe Fig. 3) weist die Leitbahnstruktur eine Kontaktzone 13 auf, die vor der Kontaktierung durch Schneiden bzw. Stanzen des Informationsträgers 1 freizulegen ist.

Es ist daher ein Kontaktierungssystem, d.h. ein System zum elektrischen Kontaktieren des Informationsträgers mit dem Kontaktelement 2 vorgesehen, das eine Schneid- oder Stanzeinrichtung 3 aufweist (siehe Fig. 2). Durch eine geeignete Führungs- und Haltevorrichtung 4 kann der Informationsträger 1 derart geschnitten bzw. gestanzt werden, dass die Kontaktzone 13 in einem Kantenbereich 14 freigelegt wird.

Nach dem Freilegen der Kontaktzone 13 wird das Kontaktelement 2 gegen die Kontaktzone gedrückt (siehe Fig. 3). Mit Hilfe einer eine Strom-/Spannungsquelle 5 wird an das Kontaktelement 2 ein Strom bzw. eine Spannung angelegt, um ein entsprechendes Signal in die Leitbahnstruktur einzukoppeln.

Zwischen der Kontaktzone 13 und dem Kontaktelement 2 wird ein ohmscher Kontakt gebildet. Die im Kantenbereich 14 freigelegte Kontaktzone 13 ist in geeigneter Weise auszubilden. Dabei kommt insbesondere eine flächige, linienförmige oder punktförmige Ausbildung in Betracht. Mit dem oben beschriebenen System bzw. Verfahren ist eine einfache und sichere Kontaktierung einer zwischen zwei Substratlagen eingebetteten Leitbahnstruktur möglich.

Handelt es sich bei dem Informationsträger um eine Eintrittskarte für eine Veranstaltung, findet durch den Schneid- bzw. Stanzvorgang gleichzeitig eine sichtbare Entwertung der Eintrittskarte statt.

## Patentansprüche

1. Verfahren zur elektrischen Kopplung eines Informationsträgers (1) mit einem Kontaktelement (2), wobei der Informationsträger eine Leitbahnstruktur (12) mit einer Kontaktzone (13) aufweist, wobei die Leitbahnstruktur (12) und die Kontaktzone unsichtbar zwischen zwei fest miteinander verbundenen Substratlagen (10, 11) eingebettet sind, und das Kontaktelement (2) mit der Kontaktzone (13) in elektrischen Kontakt gebracht wird,
**dadurch gekennzeichnet, dass** der Informationsträger (1) zur. Herstellung einer elektrischen Kopplung in einem Kontaktierungssystem zunächst derart geschnitten bzw. gestanzt wird, dass die Kontaktzone (13) in einem Kantenbereich (14) freigelegt wird und anschließend das Kontaktelement (2) in diesem Kantenbereich mit der Kontaktzone in einen ohmschen Kontakt gebracht wird.

2. Verfahren nach Anspruch 1, **dadurch gekennzeichnet, dass** der Informationsträger im Kontaktierungssystem während des Schneid- bzw. Stanzvorgangs und während der Kontaktierung mit dem Kontaktelement geführt und gehalten wird.

3. Verfahren nach Anspruch 1, **dadurch gekennzeichnet, dass** Kontaktelement (2) bei der elektrischen Kontaktierung gegen die Kontaktzone (13) gedrückt wird.

4. Verfahren zur elektrischen Kopplung eines Informationsträgers nach Anspruch 1, wobei der Informationsträger eine Eintrittskarte ist, die durch den Schneid- bzw. Stanzvorgang sichtbar entwertet wird.

5. System zum elektrischen Kontaktieren eines Informationsträgers (1), der eine Leitbahnstruktur (12) mit einer Kontaktzone (13) aufweist, wobei die Leitbahnstruktur (12) und die Kontaktzone unsichtbar zwischen zwei fest miteinander verbundenen Substratlagen (10, 11) eingebettet sind,
enthaltend
- eine Führungs- und Haltevorrichtung (4) für den Informationsträger,
- eine Schneid- oder Stanzeinrichtung (3) zum Freilegen der eingebetteten Kontaktzone (13) in einem Kantenbereich (14) des Informationsträgers,
- ein Kontaktelement (2) zur ohmschen Kontaktierung der freigelegten Kontaktzone (13),
- eine Strom-/Spannungsquelle (5) zum Anlegen eines Stromes bzw. einer Spannung an das Kontaktelement (2) und zur Einkopplung eines entsprechenden Signals in die Leitbahnstruktur.

6. System nach Anspruch 5, **dadurch gekennzeichnet, dass** die Substratlagen (10, 11) aus Papier oder Folie bestehen.

7. System nach ein oder mehreren der Ansprüche 5 bis 6 , **dadurch gekennzeichnet, dass** die beiden Substratlagen (10, 11) durch Laminieren zusammengefügt sind.

8. System nach ein oder mehreren der Ansprüche 5 bis 7, **dadurch gekennzeichnet, dass** der Informationsträger (1) flexibel ausgebildet ist.

9. System nach ein oder mehreren der Ansprüche 5 bis 8, **dadurch gekennzeichnet, dass** die Leitbahnstruktur (12) und die Kontaktzone (13) aus leitfähigen organischen Polymeren, insbesondere aus PEDOT oder PANI, bestehen.

10. System nach Anspruch 9, **dadurch gekennzeichnet, dass** die leitfähigen organischen Polymere durch ein Massendruckverfahren, insbesondere ein Hoch-, Tief- oder Flachdruckverfahren, hergestellt sind.

## Claims

1. Method for electrically coupling an information carrier (1) to a contact element (2), the information carrier having an interconnect structure (12) having a contact zone (13), the interconnect structure (12) and the contact zone being invisibly embedded between two substrate layers (10, 11) which are permanently connected to one another, and the contact element (2) being brought into electrical contact with the contact zone (13),
**characterized in that**, in order to produce electrical coupling in a contact-connection system, the information carrier (1) is first of all cut or stamped in such a manner that the contact zone (13) is exposed in an edge region (14) and the contact element (2) is then brought into ohmic contact with the contact zone in this edge region.

2. Method according to Claim 1, **characterized in that** the information carrier is guided and held in the contact-connection system during the cutting or stamping operation and during contact-connection to the contact element.

3. Method according to Claim 1, **characterized in that** the contact element (2) is pressed against the contact zone (13) during electrical contact-connection.

4. Method for electrically coupling an information carrier according to Claim 1, the information carrier being a ticket which is visibly voided by the cutting or stamping operation.

5. System for electrically contact-connecting an information carrier (1) which has an interconnect structure (12) having a contact zone (13), the interconnect structure (12) and the contact zone being invisibly embedded between two substrate layers (10, 11) which are permanently connected to one another,
said system containing
- a guiding and holding apparatus (4) for the information carrier,
- a cutting or stamping device (3) for exposing the embedded contact zone (13) in an edge region (14) of the information carrier,
- a contact element (2) for ohmically contact-connecting the exposed contact zone (13),
- a current/voltage source (5) for applying a current or voltage to the contact element (2) and for injecting a corresponding signal into the interconnect structure.

6. System according to Claim 5, **characterized in that** the substrate layers (10, 11) are composed of paper or film.

7. System according to one or more of Claims 5 to 6, **characterized in that** the two substrate layers (10, 11) are joined by means of lamination.

8. System according to one or more of Claims 5 to 7, **characterized in that** the information carrier (1) is flexible.

9. System according to one or more of Claims 5 to 8, **characterized in that** the interconnect structure (12) and the contact zone (13) are composed of conductive organic polymers, in particular PEDOT or PANI.

10. System according to Claim 9, **characterized in that** the conductive organic polymers are produced by means of a mass printing method, in particular a letterpress, gravure or planographic printing method.

## Revendications

1. Procédé de couplage électrique d'un support d'informations (1) avec un élément de contact (2), le support d'informations présentant une structure de piste conductrice (12) avec une zone de contact (13), la structure de piste conductrice (12) et la zone de contact étant enrobées de manière invisible entre deux couches de substrat (10, 11) fixées à demeure l'une à l'autre et l'élément de contact (2) étant amené en contact électrique avec la zone de contact (13),
**caractérisé en ce que** le support d'informations (1), pour établir un couplage électrique dans un système de mise en contact, est tout d'abord découpé ou poinçonné de telle sorte que la zone de contact (13) est exposée dans une zone de bordure (14) et l'élément de contact (2) est ensuite amené en contact ohmique avec la zone de contact dans cette zone de bordure.

2. Procédé selon la revendication 1, **caractérisé en ce que** le support d'informations est guidé et maintenu dans le système de mise en contact pendant l'opération de découpage ou de poinçonnage et pendant la mise en contact avec l'élément de contact.

3. Procédé selon la revendication 1, **caractérisé en ce que** l'élément de contact (2) est poussé contre la zone de contact (13) lors de la mise en contact électrique.

4. Procédé de couplage électrique d'un support d'information selon la revendication 1, le support d'informations étant une carte d'entrée qui est visiblement oblitérée par l'opération de découpe ou de poinçonnage.

5. Système de mise en contact électrique d'un support d'informations (1), lequel présente une structure de piste conductrice (12) avec une zone de contact (13), la structure de piste conductrice (12) et la zone de contact étant enrobées de manière invisible entre deux couches de substrat (10, 11) fixées à demeure l'une à l'autre,
comprenant
- un dispositif de guidage et de maintien (4) pour le support d'informations,
- un dispositif de découpe ou de poinçonnage (3) pour exposer la zone de contact (13) enrobée dans une zone de bordure (14) du support d'informations,
- un élément de contact (2) pour établir un contact ohmique avec la zone de contact (13) exposée,
- une source de courant/tension (5) pour appliquer un courant ou une tension à l'élément de contact (2) et pour injecter un signal correspondant dans la structure de piste conductrice.

6. Système selon la revendication 5, **caractérisé en ce que** les couches de substrat (10, 11) se composent de papier ou de film.

7. Système selon une ou plusieurs des revendications 5 à 6, **caractérisé en ce que** les deux couches de substrat (10, 11) sont assemblées par laminage.

8. Système selon une ou plusieurs des revendications 5 à 7, **caractérisé en ce que** le support d'informations (1) est de configuration souple.

9. Système selon une ou plusieurs des revendications 5 à 8, **caractérisé en ce que** la structure de piste conductrice (12) et la zone de contact (13) se composent de polymères organiques conducteurs, notamment de PEDOT ou de PANI.

10. Système selon la revendication 9, **caractérisé en ce que** les polymères organiques conducteurs sont fabriqués par un procédé d'impression dans la masse, notamment un procédé de typographie, d'héliogravure ou d'impression à plat.
